# EUROPEAN PATENT SPECIFICATION

(11) **EP 0 574 859 B1**
(45) Date of publication and mention of the grant of the patent: **11.03.1998**
(21) Application number: 93109473.4
(22) Date of filing: 14.06.1993
(51) Int. Cl.: H01J 37/32

(54) **Method of removing particles in a plasma processing chamber**
Partikeln-Entfernungsverfahren in einer Plasma-Bearbeitungskammer
Méthode d'enlèvement des particules dans un chambre de traitement par plasma

(30) Priority: 16.06.1992 US 899539
(43) Date of publication of application: 22.12.1993
(73) Proprietor: APPLIED MATERIALS, INC., Santa Clara, California 95054-3299 (US)
(72) Inventor: Gupta, Anand, San Jose, CA 95131 (US); Lanucha, Joseph, Sunnyvale, Ca 94086 (US)
(74) Representative: Diehl, Hermann O. Th., Dr.

(56) References cited:
- EP-A- 0 425 419
- EP-A- 0 453 780
- IBM TECHNICAL DISCLOSURE BULLETIN. vol. 34, no. 11, April 1992, NEW YORK US pages 237 - 238 'Pump/purge procedure using Neon feedstock.'

## Description

This invention relates to a method for removing particles in a plasma processing chamber.

In the manufacture of microelectronic devices, particularly VLSI and ULSI devices, in which the overall dimensions of devices are becoming bigger and more closely packed, and the critical dimensions are becoming much smaller, particle contamination is of increasing concern. The presence of particles during deposition or etching of thin films can cause voids, dislocations or shorts which adversely affect performance and reliability of the devices.

The problem of contaminant particles was addressed initially by improving the quality of clean rooms and improving automated equipment to handle materials and semiconductor substrates, e.g., silicon wafers. Improved cleaning of wafer surfaces was also addressed. These improvements have greatly reduced the number of particles that are present or fall onto a wafer surface during the processing cycle. However, many particles are generated inside the wafer processing chambers themselves due to the materials used for processing and due to mechanical means, for example the rubbing movements of robotic equipment during transfer operations and the like.

In particular during processing that uses a plasma, many fragments of various kinds are generated from the processing gases, including ions, electrons, particles, and the like. The fragments can combine to form generally slightly negatively charged particles, i.e., on the order of 10⁴ negative charge. In addition, the processing chamber becomes coated with various materials, such as polymers, during plasma processing of a wafer. Stress, such as stress due to thermal cycling and the like, causes these films to fracture and dislodge from the walls and surfaces on which they have deposited, also generating particles. In addition, particles are generated within the processing chambers during wafer transfer operations, pump oil backstreaming and the like.

Selwyn et al have disclosed one solution to avoiding deposition of particles onto a wafer. They redesigned the wafer support electrode to provide grooves therein which provide a disturbance around the periphery of the wafer, and beyond the wafer surface. This attracts particles to this disturbed region beyond the wafer so that the vacuum chamber exhaust system can carry particles away from the wafer and outside of the processing system. While a reduction of particles of up to 70% is said to be obtained, it does require redesign of wafer support electrodes and retrofitting or existing equipment, which is expensive.

Selwyn et al have also suggested that during plasma processing particles form and collect at the plasma/sheath boundary. At the end of plasma processing when the RF power is shut off, these particles fall onto the wafer. They further teach that this is a major source of particulate contamination of wafer surfaces in a plasma chamber. They suggested that the number of particles be reduced by turning off the RF power slowly, so that particles are released from the sheath region more slowly, so that they may be evacuated by the chamber exhaust system rather than drop onto the wafer. This solution however is uncontrollable at best.

Document EP 0 425 419 A3 discloses methods and apparatus for contamination control in plasma processing, wherein contamination levels in plasma processes are reduced during plasma processing, by prevention of formation of particles, by preventing entry of particles externally introduced or by removing particles spontaneously formed from chemical and/or mechanical sources. Some techniques for prevention of formation of particles include interruption of the plasma by pulsing the source of plasma energy periodically, or application of energy to provide mechanical agitation such as mechanical shockwaves, acoustic stress, ultrasonic stress, vibrational stress, thermal stress, and pressure stress. Following a period of applied stress, a tool is pumped out (if a plasma is used, the glow is first discontinued), vented, opened and flaked or particulate material is cleaned from the lower electrode and other surfaces. A burst of filtered air or nitrogen, or a vacuum cleaner is used for removal of deposition debris while the vented tool is open. Following this procedure, the tool is then to be used for product runs. Alternatively, improvement of semiconductor process yields can be achieved by addition of reagents to getter chemical precursors of contamination particulates and by filtration of particulates from feedgas before plasma processing. The efficiency and endpoint for the applied stress are determined, by laser light scattering, using a pulsed or continuous laser source, e.g. a HeNe laser.

The methods to apply stress add further costs to the system. It is therefore the object of the present invention to develop a reliable, inexpensive process to remove particles from plasma processing chambers.

This object is solved by the method according to independent claim 1. Further advantageous features, aspects, and details of the invention are evident from the dependent claims, the description, the examples and the drawings. This invention provides a method for removal of particulate contaminants especially during semiconductor processing. More particularly, this invention relates to a method for removing contaminant particles present in a plasma reactor.

Particles formed during plasma processing or dislodged during plasma processing can be removed from a reaction chamber at the end of plasma processing by a process comprising reducing the pressure inside the plasma chamber, and at the same time also increasing the flow of a processing gas to the chamber, but without increasing the pressure in the chamber, thereby sweeping the particles into the inert gas stream to the exhaust system of the reactor. RF power is maintained during this reduced pressure/increased gas flow step.

Fig. 1 is a cross sectional view of a conventional etch chamber.

Fig. 2 is a schematic diagram of a laser light scattering system useful herein.

Processes such as plasma etching are generally carried out at pressures of about 6.7 Pa (about 50 millitorr) using a stream of argon or other inert gas fed to the reactor at about 30-35 sccm (1sccm = 1.69·10⁻³Nm/s). At the end of plasma processing, in accordance with the invention, the pressure in the chamber is reduced to about 2 to 5.3 Pa (about 15-40 millitorr). This reduction in pressure is sufficient to lift the particles above the surface of obstructions in the chamber surrounding the substrate being processed, e.g., a silicon wafer, such as a clamping ring, focussing ring or clamping fingers which keep the wafer in contact with its support.

At the same time the pressure is reduced, the flow of argon or other inert gas is increased to about 100-145 sccm (1sccm = 1.69·10⁻³Nm/s), or the maximum flow rate that can be used in the particular chamber being utilized without markedly increasing the pressure in the chamber. This increased gas flow rate sweeps the elevated, loosened particles out of the chamber by the exhaust system of the processing chamber. This may require independent gas flow control and good control of the exhaust gas system.

Some type of exhaust gas throttling may also need to be provided, depending upon the particular plasma chamber employed, as will be known to one skilled in the art.

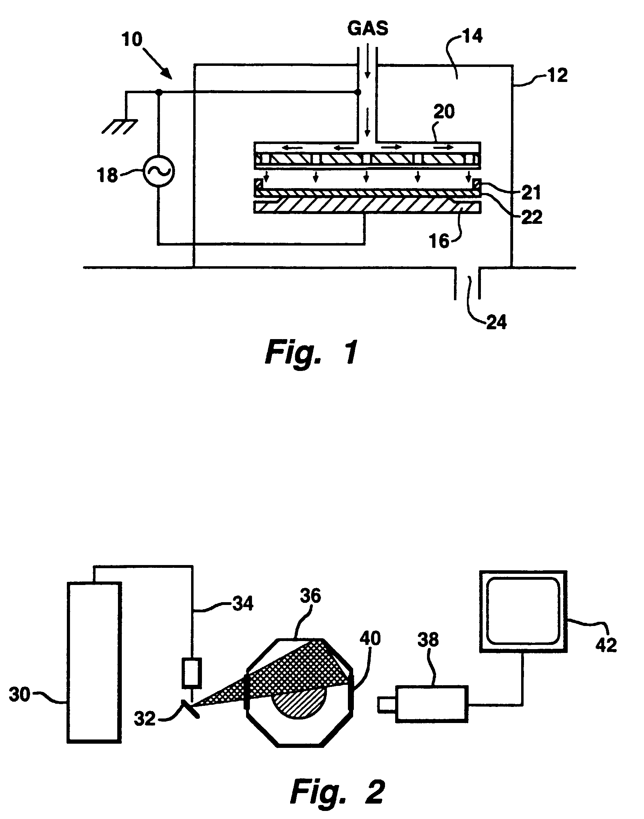

Selwyn et al have disclosed an optical system for monitoring particles inside a chamber as will be further described hereinbelow with reference to Fig. 2.

The above process for removing particles can be employed during plasma processing of any type, e.g., during plasma sputter etching, PECVD and the like. The present process is particularly advantageous for present-day multichamber equipment whereby various processing chambers, including PECVD and plasma etch chambers, communicate by means of a central load lock chamber. In such apparatus, described for example in US Patent 4,951,601 to Maydan et al, a wafer is automatically transferred into a central load lock chamber containing robotic equipment for transferring a wafer to various processing chambers connected to the load lock chamber. If the wafer is to be transferred to a PECVD chamber, the wafer is robotically transferred from the central load lock chamber to a PECVD chamber for processing. When this processing step is completed, the wafer is robotically transferred back to the central load lock chamber. If the wafer is to be treated in a subsequent, different step, e.g., heat treated or etched, the conditions in the central load lock chamber are adjusted if required, the wafer is robotically transferred to the next processing chamber, and so forth. It will be readily apparent that the generation of particles within the whole system should be kept as low as possible, and that any loose particles on the surface of the wafer should be removed as much as possible prior to transferring the wafer to the next chamber. Otherwise in time the number of particles in the system builds up and eventually the system must be disassembled for cleaning. This of course greatly increases the downtime of the equipment and adds to the costs of processing a wafer. Thus the present method of removing particles can be utilized several times during the course of processing a wafer.

A conventional etch chamber is shown in Fig. 1 and is described below. Referring to Fig. 1, an etch reactor 10 comprises a housing 12, typically made of a non-magnetic material such as aluminum and defines an etch chamber 14. A cathode 16 for supporting the wafer to be processed is connected to a source 18 of RF energy. Processing gases are supplied to the chamber 14 via a gas manifold 20. The gas manifold 20 is positioned over and closely spaced to the cathode 16. A wafer 22 to be processed is positioned on the cathode support 16 and affixed to the cathode by means of a clamping ring 21. An exhaust line 24, connected to a vacuum pump (not shown) continually evacuates the chamber 14. In operation, the gas supply is started and the RF power is turned on, when a plasma forms in the space between the gas manifold 20 and the wafer 22.

An etch chamber having a wafer transfer system that reduces the generation of particles is described in US Patent 4,951,601. However, I have found that particles are nevertheless generated in the plasma, either through a combination of various plasma species or because of flaking of deposited material on the walls and other surfaces of the chamber.

Fig. 2 is a schematic diagram of a laser light scattering system useful for the observation of particles and their behavior within a plasma etch system.

Referring to Fig. 2, an argon laser 30 is connected to a scanner 32 by means of a fiber optic cable 34. Suitably the laser is a 5W water cooled multiple line argon laser coupled to a fiberoptic cable. This cable can be mounted in a laser holder attached to a vertical shaft supported on a rotational base. Other lasers can also be used however. The scanner 32, a galvanometer, is mounted on a custom holder attached to an adjustable vertical stage. The laser and the scanner slide on an optical rail situate parallel to the chamber viewport. This arrangement provides X, Y and Z motion and adjustment of the laser. The consistency of the light plane is controlled by a frequency generator input of 0.1Hz to about 500Hz. The amount of oscillation (the angle of rotation) can be varied by an input amplitude voltage up to one volt. A DC offset controls the starting position of the angle of rotation. The scanner 32 accesses the interior of an etch chamber 36. A three chip CCD high resolution RGB video camera 38 is mounted on an angular adjustable platform attached to a vertical shaft that slides on an optical rail. The camera has access to the interior of the etch chamber 36 by means of a window 40 in the wall of the chamber. The camera 38 is set up to provide various focal lengths by adjustment of the viewing distance from the window 40 to the camera 38. The video camera 38 is connected to a TV monitor 42 for viewing the particles inside the chamber 36.

The above system was set up so that the focus distance between the end of the fiber optic laser source and the scanner was about 7.6 to 10.2 cm ( approximately 3-4 inches) on a 12.5 mm round mirror, oscillating at 300Hz. The laser intensity was 1.75 W at a wavelength of 514.5 nm. The beam was projected through the chamber window and terminated on the interior chamber wall at 45 degrees from the point of entry. The beam had a divergence of about 2.5 cm (about one inch) and a length of 10.2 to 15.3 cm (4-6 inches) from the slit valve entry to the exit viewport. The TV camera was set so that it had a view through the exit window and was focused on the edge of the wafer nearest the slit valve. It had a slight downward angle that provided a view just inside of the wafer clamping ring. The distance from the camera to the edge of the wafer was about 30.5 to 33 cm (about 12-13 inches).

The following examples demonstrate the invention.

Although the examples are described in terms of specific embodiments, one skilled in the art will know how to vary them and still obtain similar results and the invention as claimed is not meant to be limited to the details described herein.

### Example 1

Using the above described argon laser system of Fig. 2 at a power of about 100-200 W and scanning frequencies of from lOHz to 300Hz, the pressure in a plasma chamber containing a silicon wafer was set at about 6.7 to 93.3 Pa (about 50-700 millitorr). A flow of argon started varying from about 20-75 sccm (1sccm = 1.69·10⁻³ Nm/s). While observing the plasma region, various parameters were changed so as to observe the shape and thickness of the plasma sheath region within the chamber. A change in the position of the boundary sheath was noted with change in pressure; as the pressure was increased from 6.7 Pa (50 millitorr) to 93.3 Pa (700 millitorr), the glow region increased and the boundary sheath region decreased. We also observed that the plasma/boundary sheath was well-shaped, and followed the contour of the clamping ring for the wafer. At 6.7 Pa (50 millitorr) the sheath was about 1.3 cm (about 0.5 inch) thick. When the clamping ring was removed, the shape of the boundary sheath was that of a dome. Particle light scattering was noted at 200 W and 6.7 Pa (50 millitorr) pressure using a gas flow of 25 sccm of argon after about one second using 1.75 W laser intensity. When the chamber was doped with alumina particles, the particles hovered about 1.3 cm (about 0.5 inch) above the surface of the wafer and at the interface of the wafer and the clamping ring. The particles ranged in size from about 1.6-3.0 µm. When the RF power was turned off, the particles appeared to fall back onto the wafer.

### Example 2

Using a tungsten etch chamber as in Fig. 1, a blanket tungsten layer over a TiN layer on a silicon wafer was reactive ion etched. At the end of etch processing, without turning the RF power off, the pressure was reduced to 4 to 5.3 Pa (30 to 40 millitorr), the RF power was maintained at 200 W and argon flow was increased to about 130 sccm (1sccm = 1.69·10⁻³Nm/s).

A large number of particles were observed in the exhaust line of the chamber using an in-situ particle monitor described in U.S. Patent 5, 083 865 after adjustment of pressure and argon flow, leading to the conclusion that extra particles trapped in the plasma were being exhausted along with argon gas.

### Example 3

An etch chamber was doped with alumina particles about 1.6-3.0 µm in diameter in size. The RF power was turned on and a flow of argon started. A plasma was formed. Initially these particles were observed to be trapped in the plasma/sheath boundary region. The number of particles being exhausted by the etch chamber can be monitored by a particle monitor system as described in US Patent 5,083,865 to Kinney et al, incorporated herein by reference. By maintaining a low pressure of 3.3 Pa (about 25 millitorr), and increasing the flow of argon from about 25 sccm to about 145 sccm (1sccm = 1.69·10⁻³Nm/s), the particles were cleared from the plasma/sheath boundary region in which they were trapped. At the end of this step, no alumina particles were observed within the plasma/sheath boundary region by laser light scattering.

Although the invention as claimed has been described in terms of processing a wafer, it will be understood that various other substrates can be employed herein. Further, although the process has been applied to removing particles after plasma processing, the process is equally applicable to removing particles from the surface of a wafer prior to plasma processing. The method is independent of the particular plasma apparatus employed and is applicable to removing particles in any type of plasma chamber.

The present invention as claimed has been described by means of specific embodiments and processes. However, one skilled in the art can readily vary the equipment and parameters described, and the invention is meant to be limited only by the scope of the attached claims.

## Claims

1. A method of removing particles in a plasma processing chamber containing a substrate being plasma processed comprising
a) reducing the pressure of the chamber from the pressure which is used for processing the substrate so that the particles are elevated above any obstructions near the substrate being processed; and
b) increasing the flow of processing gases from the gas flow which is used for processing the substrate to carry the elevated particles in the gas stream away from the surface of the substrate.

2. The method according to claim 1 wherein the process is an etch process and the process gas is argon.

3. The method according to claim 1 or 2 wherein the pressure in step a) is reduced to 2 to 5.3 Pa (15 to 40 millitorr).

4. The method according to one of the preceding claims wherein the gas flow is increased to 0.169 to 0.245 Nm/s (100 to 145 sccm).

5. The method according to claim 4 wherein the argon flow is increased to 0.2028 to 0.228 Nm/s (120 to 135 sccm).

## Patentansprüche

1. Verfahren zur Entfernung von Partikeln in einer Plasmaverarbeitungskammer mit einem Substrat, welches plasmabearbeitet wird, das folgendes umfaßt:
a) Reduzieren des Drucks der Kammer von dem Druck, welcher zur Verarbeitung des Substrat verwendet wird, so daß die Partikel über jegliche Hindernisse in der Nähe des Substrats, welches bearbeitet wird, erhoben werden; und
b) Steigern des Stroms an Prozeßgasen von dem Gasstrom, welcher zur Verarbeitung des Substrats verwendet wird, um die erhobenen Partikel in dem Gasstrom von der Oberfläche des Substrats wegzutragen.

2. Verfahren gemäß Anspruch 1, bei dem das Verfahren ein Atzprozeß ist und das Prozeßgas Argon ist.

3. Verfahren gemäß Anspruch 1 oder 2, bei dem der Druck in Schritt a) auf 2 bis 5,3 Pa (15 bis 40 Millitorr) reduziert wird.

4. Verfahren gemäß einem der vorhergehenden Ansprüche, bei dem der Gasstrom auf 0,169 bis 0,245 Nm/s (100 bis 145 sccm) erhöht wird.

5. Verfahren gemäß Anspruch 4, bei dem der Argonstrom auf 0,2028 bis 0,228 Nm/s (120 bis 135 sccm) erhöht wird.

## Revendications

1. Procédé d'enlèvement de particules dans une chambre de traitement par plasma contenant un substrat qui est traité par le plasma, comprenant les étapes :
a) de réduction de la pression régnant dans la chambre, par rapport à la pression utilisée pour traiter le substrat, de sorte que les particules sont soulevées au-dessus de tout obstacle se trouvant à proximité du substrat traité ; et
b) à augmenter le débit de gaz de traitement, par rapport au débit de gaz utilisé pour traiter le substrat, afin de transporter les particules soulevées dans le courant de gaz, à l'écart de la surface du substrat.

2. Procédé selon la revendication 1, dans lequel le procédé est un procédé de gravure et le gaz de traitement est de l'argon.

3. Procédé selon la revendication 1 ou 2, dans lequel la pression de l'étape a) est réduite jusqu'à 2 à 5,3 Pa (15 à 40 millitorr).

4. Procédé selon l'une des revendications précédentes, dans lequel le débit de gaz est accru jusqu'à 100 à 145 cm³/mn (0,169 à 0,245 Nm/s).

5. Procédé selon la revendication 4, dans lequel le débit d'argon est accru jusqu'à 120 à 135 cm³/mn (0,2028 à 0,228 Nm/s).
